Europäisches Patentamt

European Patent Office

Office européen des brevets

(11) Veröffentlichungsnummer: **0 316 275**
**A2**

(12) **EUROPÄISCHE PATENTANMELDUNG**

(21) Anmeldenummer: 88810744.8

(22) Anmeldetag: 02.11.88

(51) Int. Cl.⁴: **C 25 D 13/02**

(30) Priorität: 10.11.87 CH 4378/87

(43) Veröffentlichungstag der Anmeldung:
17.05.89 Patentblatt 89/20

(84) Benannte Vertragsstaaten:
CH DE FR GB IT LI NL SE

(71) Anmelder: **CIBA-GEIGY AG**
**Klybeckstrasse 141**
**CH-4002 Basel (CH)**

(72) Erfinder: **Mizuguchi, Jin, Dr.**
**Rte de Schiffenen 7**
**CH-1700 Fribourg (CH)**

**Kudo, Tetsu, Dr.**
**4-3-912 Mukogawa-Cho**
**Takarazuka-Shi Hyogo (JP)**

(54) Verfahren zur Herstellung von supraleitenden Materialien in an sich beliebiger Form.

㊗ Verfahren zur Herstellung von supraleitenden Materialien in an sich beliebiger Form, dadurch gekennzeichnet, dass man auf Metallelektroden oder metallisierten Elektroden entsprechender Form aus einer Suspension eine supraleitende keramische Verbindung elektrophoretisch abscheidet und die beschichtete Elektrode anschliessend bei erhöhter Temperatur sintert.

EP 0 316 275 A2

Beschreibung

## Verfahren zur Herstellung von supraleitenden Materialien in an sich beliebiger Form

Die vorliegende Erfindung betrifft ein neues Verfahren zur Herstellung von supraleitenden Materialien in an sich beliebiger Form und die so erzeugten supraleitenden Materialien.

Supraleitende keramische Pulver sind aus verschiedenen Literaturstellen, z.B. Zeitschrift für Physik B-Condensed Matter 64, S. 189-193 (1986) [für Ba-La-Cu-O-Systeme], Phys. Rev. Let. 58, No. 16 (1987), S. 1676-79 [für Ba-Y-Cu-O-Systeme], Phys. Rev. Let. 58, No. 18 (1987), S. 1888-90 [für La-Ba-Cu-O-Systeme], und Phys. Rev. Let. 58, No. 24 (1987), S. 2579-81 [für Y-Ba-Cu-F-O-Systeme], bekannt.

Es wurden auch schon supraleitende Drähte nach der sogenannten Bronze-Methode, Standardtechnik zur Herstellung von $Nb_3Sn$-Drähten, [vgl. z.B. Function Materials, Bd. 6, Nr. 1, S. 15-23 (1986)] hergestellt, indem man das supraleitende keramische Pulver, z.B. Mischoxide aus Y, Ba und Cu oder aus La, Sr und Cu, in ein Röhrchen z.B. aus einer Kupferlegierung, wie Bronze, oder aus Silber einfüllt, das Röhrchen auf den gewünschten Drahtdurchmesser auszieht und anschliessend bei höherer Temperatur sintert [vgl. z.B. Nikkei New Materials Nr. 27 (1987), S. 85-86, Herausgeber Nikkei McGraw Hill]. Diese Methode ist insbesondere bei dünnen Röhrchen in Bezug auf ihre Durchführung nicht einfach: Die Einfüllung der Mischoxide ist oft erschwert, was zur Bildung unregelmässiger Oxidschichten führt, die nach dem Sintern ungleichmässige und nicht-porenfreie Beschichtungen ergeben.

Mit Hilfe der Sputtering-Technik (Vakuum-Verfahren) lassen sich dünne Platten, z.B. Saphir- oder $SrTiO_3$-Platten, mit supraleitenden Schichten überziehen [vgl. z.B. Nikkei New Materials Nr. 27 (1987), S. 76-84 und 85-86].

Schliesslich ist es bekannt, dass durch Plasma-Spritzen relativ dicke supraleitende Schichten auf flachen Substraten erzeugt werden können [vgl. z.B. Nikkei Hew Materials Nr. 31 (1987), S. 13].

Diese Verfahren sind insofern nachteilig, als damit im allgemeinen nur flache Formkörper oder Substrate beschichtet werden können. Zudem können die Ausgangsmaterialien bei der Sputtering-Technik und dem Plasma-Spritzen nicht optimal ausgenützt werden, da ein Teil davon nicht gezielt auf das zu beschichtende Substrat gerichtet werden kann. Es ist im allgemeinen auch recht schwierig, mit diesen Verfahren auf wirtschaftliche Weise gleichmässige Schichten hoher Dichte zu erzeugen. Ausserdem ist die Adhäsion zwischen dem Substrat und der supraleitenden Schicht nicht immer optimal.

Gegenstand der Erfindung ist ein Verfahren zur Herstellung von supraleitenden Materialien in an sich beliebiger Form, indem man auf Metallelektroden oder metallisierten Elektroden entsprechender Form aus einer Suspension eine supraleitende keramische Verbindung elektrophoretisch abscheidet und die beschichtete Elektrode anschliessend bei erhöhter Temperatur sintert. Gewünschtenfalls kann anschliessend auf der beschichteten und gesinterten Elektrode z.B. aus einer wässrigen oder nicht-wässrigen Lösung elektrochemisch eine Metallbeschichtung erzeugt werden.

Die supraleitende keramische Verbindung kann an sich beliebiger Art sein. Bevorzugt ist die supraleitende keramische Verbindung eine solche mit einer Sprungtemperatur $T_c$ von mindestens 4 K, besonders eine Verbindung mit einer Sprungtemperatur $T_c$ zwischen 10 und 125 K oder mehr. Als Beispiele solcher Verbindungen seien genannt:

|  | $T_c$ (K) |
|---|---|
| $LiTi_2O_4$ | 13,7 |
| $Ba(Pb \bullet Bi)O_3$ | 13 |
| $PbMo_6S_8$ | 15 |
| $Mo_6S_6I_2$ | 14 |
| $LaMo_6Se_8$ | 11,6 |
| $Mo_6Se_8$ | 6,3 |
| $La_3S_4$ | 8,3 |
| $NbSe_2$ | 7,3 |
| $AgSnS_2$ | 6,9 |
| $CuRh_2S_4$ | 4,8 |
| $NbN$ | 15,6 |
| $ZrN$ | 10,7 |
| $Nb(C \bullet N)$ | 17 |
| $MoC$ | 13 |
| $TaC$ | 11,4 |
| $NbC$ | 11 |
| $NbB$ | 8,3 |
| $ErRh_4B_4$ | 8,7 |
| Rubidiumwolframat | 6,4 |
| Lithiumtitandisulfid | 13 |

[vgl. Function Materials Bd. 6, Nr. 1, S. 52-60 (1986)], sowie $La_2CuO_{4-y}$ (y = 0-0,1), $BaPb_{1-x}Bi_xO_3$ mit x = 0,1-0,6 und Mischoxide aus Wismuth, Blei, Strontium, Calcium und Kupfer.

Bevorzugt ist die supraleitende keramische Verbindung ein Mischoxid aus mindestens einer seltenen Erde, einem Erdalkalimetall und Kupfer, insbesondere ein Mischoxid aus Lanthan, Kupfer und Barium, Strontium oder Calcium.

Als Beispiele solcher Verbindungen seien $La_{1,85}Sr_{0,25}CuO_4$ und $La_{0,85}Ba_{0,15}CuO_{2,425}$ genannt. Diese Verbindungen weisen eine Kristallstruktur vom $K_2NiF_4$-Typ und eine Sprungtemperatur zwischen 30 und 40 K auf.

Weitere bevorzugte supraleitende keramische Verbindungen sind solche der Formel I
$MBa_2Cu_3O_x$     (I),
worin x zweckmässig 4,5 bis 6,95 ist und der Rest M Lu, Yb, Tm, Er, Dy, Ho, Tb, Gd, Eu, Sm, Sc oder Y darstellt.

Die Verbindungen der Formel I weisen Dreischicht-Perovskitstruktur auf. Besonders bevorzugt sind Verbindungen der Formel 1, worin M Yttrium bedeutet und x die unter Formel I angegebene Bedeutung hat.

Ganz besonders bevorzugte supraleitende keramische Verbindungen sind Mischoxide aus Wismuth, Strontium, Calcium und Kupfer, wie z.B. die in Jpn. J. Appl. Phys. 27, L-209-210 (Febr. 1988), L323, L344, L347 und L358-361 (März 1988) beschriebenen Bi-Sr-Ca-Cu-0-Systeme, oder Mischoxide aus Thallium, Barium, Calcium und Kupfer, wie z.B. die in Jpn. J. Appl. Physik. 27, L559-560 und L591-593 (April 1988) oder in Nature 332 (März 1988), S. 138-139 beschriebenen Tl-Ba-Ca-Cu-O-Systeme. Für derartige Systeme werden dort verschiedene Zusammensetzungen und Kristallstrukturen vorgeschlagen, wie etwa in der folgenden Tabelle zusammengefasst:

| $T_c$ (k) | Zusammensetzung |
|---|---|
| 75-80 (Phase I) | $Bi_2CaSr_{1,5}Cu_2Ox$ $Bi_4Sr_3Ca_2Cu_4Ox$ |
| 105-110 (Phase II) | $BiSrCaCu_2Ox$ $Bi_4Sr_3Ca_3Cu_6Ox$ |
| 110-125 (Phase I) | $Tl_2Ba_2Ca_2Cu_3Ox$ |
| 100 (Phase II) | $Tl_2Ba_2CaCu_2Ox$ |

Für die Erzeugung der supraleitenden Materialien bzw. der supraleitenden keramischen Beschichtungen auf den Metallelektroden oder metallisierten Elektroden können verschiedene Ausgangsprodukte oder Verfahren angewendet werden, z.B.

(a) Verwendung von vorgesinterten Pulvern aus den abzuscheidenden supraleitenden Verbindungen. Zur Herstellung der vorgesinterten Pulver werden zweckmässig Pulver aus geeigneten anorganischen Ausgangsmaterialien in den gewünschten Molgewichtsverhältnissen gemischt und bei Temperaturen z.B. von 600-1050°C vorgesintert, im allgemeinen während 2-24 Stunden. Als geeignete anorganische Ausgangsmaterialien kommen z.B. die entsprechenden Oxide, Hydroxide, Carbonate, Halogenide und Nitrate oder Gemische davon, in Betracht, die unter den Sinterbedingungen feste Lösungen bilden können. So setzt man mit Vorteil ein Oxid einer definitionsgemässen seltenen Erde, Kupferoxid und für die restlichen Ausgangsmaterialien entsprechende Oxide oder Carbonate, in den entsprechenden Molgewichtsverhältnissen ein. Anstelle von Oxiden können auch Fluoride oder Carbonate verwendet werden. Zur Herstellung von Schichten aus Sulfiden setzt man mit Vorteil die entsprechenden Metallsulfide und/oder Metallhalogenide ein.

Das Sintern kann auf an sich bekannte Weise durchgeführt werden, d.h. in der Luft, in Sauerstoff oder in einer Inertgasatmosphäre, wie Stickstoff oder Argon.

(b) Verwendung von nach der sogenannten Mitfällungsmethode hergestellten Pulvern. Dabei wird zuerst z.B. ein Metall-Oxalat der gewünschten Zusammensetzung (z.B. ein Gemisch aus einer seltenen Erde, einem Erdalkalimetall und Kupfer) hergestellt und dieses wie unter (a) beschrieben vorgesintert, vorzugsweise bei 400-600°C und während 2-4 Stunden. Das Metall-Oxalat kann z.B. aus wässrigen sauren Lösungen geeigneter anorganischer Ausgangsmaterialien, z.B. die entsprechenden Oxide oder Halogenide, durch Ausfällung in einer Oxalsäurelösung hergestellt werden.

Weitere Mitfällungsmethoden sind z.B. in Nikkei Neu Materials Nr. 31 (1987), S. 31-32 beschrieben.

(c) Anstelle der vorgesinterten supraleitenden Pulver gemäss (a) können auch pulverförmige Vorstufen davon, die nach der elektrophoretischen Abscheidung beim anschliessenden Sintern die gewünschte supraleitende Verbindung bilden, eingesetzt werden. Geeignete Ausgangsmaterialien sind unter (a) erwähnt.

Vor der elektrophoretischen Abscheidung werden die unter (a), (b) und (c) beschriebenen Pulver zweckmässig zu einem feinteiligen Material vermahlen. Die mittlere Partikelgrösse kann z.B. bis zu 50 μm betragen, liegt aber im allgemeinen zwischen 0,1 und 15 μm, besonders zwischen 0,1 und 5 μm.

Nach der Mitfällungsmethode (b) werden unter Umständen direkt Pulver ausreichender Feinheit (durchschnittliche Partikelgrösse z.B. zwischen 0,1-0,5 μm und weniger als 1 μm) erhalten, so dass sich ein weiteres Vermahlen vor der Dispergierung im Abscheidungsmedium erübrigt.

Als Beispiele von geeigneten Metallelektroden bzw. metallisierten Elektroden seien solche aus Edelmetallen, wie Gold, Silber und Platin, Heizdrähte, z.B. solche aus Ni-Cr und CrAlCo, durchsichtige Elektroden, z.B. aus $SnO_2$:Sb oder $In_2O_3$, ferner Indium-Zinn-Oxid-Elektroden. Elektroden aus hitzebeständigen und anti-korrosiven Ni-Legierungen, wie die unter dem Handelsnamen bekannten "Hastelloy"-Legierungen, Elektroden aus Fe, nicht-rostendem Stahl (Fe-Cr), $PbO_2$, Ni, NiO, Ti, $TiO_2$, $Ag_2O$, ZnO, Cu, W und Mo erwähnt. Elektroden aus Cu, W, Fe, Ti und nicht-rostendem Stahl (Fe-Cr) und Mo sollten vorzugsweise in reduzierender Atmosphäre oder in Inertgasatmosphäre, z.B. unter Argon oder Stickstoff, eingesetzt werden.

Die Elektroden können in an sich beliebiger Form vorliegen, beispielsweise in Form von Spulen, Platten, Drähten oder Gehäusen. Supraleitende Spulen finden vor allem Anwendung als Supraleitermagneten, während sich supraleitende Drähte vor allem für die Uebertragung von Elektrizität eignen. Supraleitende Platten dienen insbesondere zur Abschirmung magnetischer Felder.

Eine weitere Anwendung ist die Herstellung von supraleitenden Magneten für "linear motor locomotives". Dies ermöglicht es, dass der Zug auf einem Magnetfeld schweben und ohne mechanische Verbindung und Reibung fahren kann.

Die erfindungsgemässe elektrophoretische Abscheidung kann in wässrigem oder nicht-wässrigem organischem Medium durchgeführt werden.

Als wässriges Medium kommen rein wässrige Systeme oder wasserhaltige Systeme, die z.B. ein organisches polares Lösungsmittel oder Gemische derartiger Lösungsmittel, z.B. bis zu etwa 95 Gew.-%, enthalten, in Betracht.

Geeignete polare Lösungsmittel sind beispielsweise niedere Alkanole, bevorzugt solche mit bis zu 6 C-Atomen, wie Methanol, Ethanol, Propanol, Isopropanol, n- und iso-Butylalkohol, Pentanole und Hexanole.

Ein bevorzugtes System ist Isopropanol, der bis zu ca. 10 Gew.-% Wasser enthält.

Derartigen wässrigen Systemen setzt man zweckmässig Elektrolyten zu, insbesondere Ammoniumnitrat, -chlorid oder -bromid oder Nitrate, Chloride oder Bromide von Elementen der Gruppen Ia, IIa, IIIa oder IIIb des Periodensystems, wie z.B. Na-, K-, Li-, Mg-, Ca-, Ba-, Sr-, Lanthaniden-und Al-nitrate, -chloride oder -bromide. Bevorzugt sind die Nitrate, besonders Magnesium-, Aluminium-, Lanthan- und Ammoniumnitrat. Ganz bevorzugt ist Lanthannitrat. Die Elektrolyten werden zweckmässig in einer Menge von 0,05 bis 4 Gew.-%, bevorzugt von 0,65 bis 1,30 Gew.-%, bezogen auf das Lösungsmittel, eingesetzt.

Bei der kathodischen Abscheidung aus wässrigen Systemen ist der elektrische Widerstand der Suspension gering, höchstens aber $10^4$ $\Omega$cm (entspricht einer elektrischen Leitfähigkeit von mindestens 100 $\mu$S/cm), so dass bevorzugt nur hochleitende Elektroden eingesetzt werden, z.B. Metallelektroden aus Gold, Silber, Platin, Kupfer, Nickel, Eisen, Molybdän oder Wolfram.

Die Ausscheidung aus wässrigen Systemen erfolgt zweckmässig bei 10 bis 500 V, bevorzugt bei 100 bis 300 Volt, und bei einer Stromdichte zwischen 5 und 30, insbesondere von etwa 10 mA/cm².

Bevorzugt ist die anodische Abscheidung aus nicht-wässrigem organischem Medium, da sich damit sehr glatte, porenfreie Ueberzüge, eine hohe Dichte der Beschichtungen und kurze Abscheidungszeiten erzielen lassen. Diese betragen im allgemeinen etwa 0,1-5 Sekunden für Schichtdicken von 100 $\mu$m gegenüber ca. 15-90 Sekunden für dieselbe Schichtdicke bei der Abscheidung aus wässrigen Systemen. Ausserdem können bei der Abscheidung aus nicht-wässrigen Systemen metallische Verunreinigungen weitgehend vermieden werden, und als Metallelektroden bzw. metallisierte Elektroden lassen sich wegen des relativ hohen elektrischen Widerstands (ca. $10^5$ $\Omega$cm) nicht nur die oben erwähnten Elektroden aus hochleitenden Metallen, sondern auch hoch-ohmige Elektroden aus Metalloxiden, wie durchsichtige Elektroden aus SnO₂:Sb (sogenannte "Nesa"-Elektroden) und In₂O₃, Indium-Zinn-Oxid-Elektroden, Elektroden aus PbO₂, NiO, TiO₂, Ag₂O und ZnO, ferner Heizdrähte aus Ni-Cr oder CrAlCo, Elektroden aus nicht-rostendem Stahl, wie Fe-Cr-Elektroden, oder Elektroden aus hitzebeständigen und antikorrosiven Ni-Legierungen, wie die vorerwähnten "Hastelloy"-Legierungen, verwenden.

Bevorzugt werden Elektroden aus Gold, Silber, Platin, Ni-Cr, CrAlCo oder Hastelloy-Legierungen eingesetzt.

Die Abscheidung aus nicht-wässrigen Systemen wird zweckmässig in Gegenwart

    (i) eines im wesentlichen wasserfreien organischen Lösungsmittels,
    (ii) einer starken Base als Elektrolyt,
    (iii) einer starken Säure und
gegebenenfalls
    (iv) eines im Lösungsmittel (i) gelösten Bindemittels vorgenommen.

Als im wesentlichen wasserfreie organische Lösungsmittel (i) kommen besonders hochreine organische Lösungsmittel mit einem hohen elektrischen Widerstand (mindestens $10^5$ $\Omega$ cm) in Betracht. Zweckmässig werden organische Lösungsmittel mit einem niedrigen Dampfdruck eingesetzt, da sie die Herstellung stabiler Systeme (keine bzw. geringe Verdunstung des Lösungsmittels während der Abscheidung) erlauben. Besonders geeignet sind hochreine (elektronische Reinheit) ketonische Lösungsmittel, wie z.B. Aceton, Methylethylketon, Diethylketon, Methylisobutylketon und Di-isobutylketon, sowie Gemische davon. Ganz besonders bevorzugt verwendet man hochreines Aceton.

Beispiele von stark basischen Elektrolyten (ii) sind NaOH, KOH und vor allem Tetraalkylammoniumsalze der Formel
$N(C_nH_{2n+1})_4X$ ,
worin n eine Zahl von 1-18, besonders 1-12 und vor allem 1-4 bedeutet und X OH oder Halogen darstellt, wie Cl, Br oder I. Besonders bevorzugt sind Tetraalkylammoniumhydroxide mit je 1-4 C-Atomen in den Alkylgruppen, ganz besonders hochreines Tetramethylammoniumhydroxid.

Als starke Säuren (iii) kommen beispielsweise Schwefelsäure und Phosphorsäure in Betracht. Bevorzugt ist hochkonzentrierte Schwefelsäure (95-98%ig).

Die starke Base und/oder die starke Säure werden zweckmässig in einer solchen Menge eingesetzt, dass die elektrische Leitfähigkeit des Systems zwischen 1 und 50 $\mu$S/cm beträgt.

Zur Verbesserung der Abscheidung kann dem Lösungsmittel (i) ein darin lösliches Bindemittel (iv) zugesetzt werden. Vorzugsweise handelt es sich um polymere organische Bindemittel, wie Nitrocellulose, Celluloseester, wie Celluloseacetat, -propionat und -butyrat oder Gemische davon, oder Polymethylmethacrylat. Nitrocellulose ist besonders bevorzugt, u.a., weil sie bei relativ niedriger Temperatur (ca. 120°c) zersetzbar ist, keine die Abscheidung störenden Rückstände hinterlässt und eine hohe Oberflächenaktivität und ein hohes Dispergiervermögen aufweist. Im allgemeinen werden dem Lösungsmittel (i) zwischen 0,05 und 0,8 Gew.-%, bevorzugt 0,2 bis 0,4 Gew.-% Bindemittel (iv) zugesetzt.

Die Abscheidung aus nicht-wässrigen Systemen erfolgt zweckmässig bei etwa 10 bis 1000 V, bevorzugt 200 bis 600 V und einer Stromdichte zwischen 0,5 und 3 mA/cm², bevorzugt zwischen 1 und 1,5 mA/cm². Die einzusetzende Spannung hängt von der Grösse und Form der Elektroden ab, wobei in der Regel für grössere Elektroden höhere Spannungen eingesetzt werden.

Das Sintern der beschichteten Elektroden kann nach üblichen Methoden durchgeführt werden, vorzugsweise bei Temperaturen zwischen 600 und 1050°C, in der Luft, in Sauerstoff oder in Inertgasatmosphäre, z.B. unter Argon oder Stickstoff. Die Sinterdauer liegt im allgemeinen zwischen 2 und 24 Stunden. Die Sinterung kann in einem Ofen üblicher Art vorgenommen werden, oder aber die beschichteten Elektroden, insbesondere Drähte, können selber als Heizelement (bzw. Heizdraht) verwendet werden.

Man erhält supraleitende, gleichmässige, weitgehend porenfreie und dichte Beschichtungen, deren Haftfestigkeit auf der Metallelektrode gut ist. Ausserdem kann bei Spulen eine einwandfreie innere Beschichtung erzielt werden.

Nach dem Abkühlen können die beschichteten gesinterten Elektroden bzw. supraleitenden Materialien, wie schon erwähnt, z.B. aus einer wässrigen oder nicht-wässrigen Lösung elektrochemisch mit Metallen beschichtet werden. Dadurch wird eine Stabilisierung der supraleitenden keramischen Schicht erzielt bzw. Löschungseffekte vom supraleitenden in den normal leitenden Zustand wegen lokal auftretender sog. "flux jumps" können verhindert oder zum mindesten verringert werden.

Als Metalle zur Erzeugung solcher stabilisierender Ueberzüge aus einer wässrigen Lösung eignen sich z.B. Cu, Ni, Cr, Zn, Sn, Ag, Au, Cu-Zn und Cu-Sn. Gold und insbesondere Kupfer sind bevorzugt. Die elektrochemische kationische Beschichtung mit derartigen Metallen kann unter Verwendung üblicher elektrochemischer Abscheidungsbäder und -bedingungen vorgenommen werden. Als typische Abscheidungsbäder/-bedingungen seien erwähnt (Spannung jeweils zwischen 1,5 und 10 Volt während 2-3 Minuten zur Erzeugung von Schichtdicken zwischen 2 und 5 μm):

| abzuscheidendes Metall | Zusammensetzung des Abscheidungsbades [g/l Wasser] | | Abscheidungsbedingungen |
|---|---|---|---|
| Cu | Cu-So$_4$•5H$_2$O | 200 | 0,5-1,5 A/dm² bei 20-30°C |
| | H$_2$SO$_4$ | 50 | |
| Ni | Ni-So$_4$•7H$_2$O | 150 | pH = 5,6-6,2 |
| | NH$_4$Cl | 15 | 0,5-1,0 A/dm² |
| | H$_3$BO$_3$ | 13 | |
| Cr | CrO$_3$ | 250 | 10-60 A/dm² bei 45-55°C |
| | H$_2$SO$_4$ | 2,5 | |
| Zn | Zn(CN)$_2$ | 60 | 1-5 A/dm² bei 25-30°C |
| | NaCN | 40 | |
| | NaOH | 80 | |
| Sn | Sn(BF$_4$)$_2$ | 200 | 2,5-12 A/dm² bei 20-50°C |
| | HBF$_4$ | 100 | |
| | H$_3$BO$_3$ | 25 | |
| | Gelatine | 6 | |
| Ag | AgCN | 36 | 0,3-1,5 A/dm² bei 20-30°C |
| | KCN | 60 | |
| | K$_2$CO$_3$ | 45 | |
| Au | Au | 2 | 0,1-0,5 A/dm² bei 60-70°C |
| | KCN | 15 | |
| | Na$_2$HPO$_4$ | 4-8 | |
| Cu-Zn | Cu(CN)$_2$ | 30 | pH = 10,5-11,5 |
| | Zn(CN)$_2$ | 10 | 0,5 A/dm² bei 25-35°C |
| | NaCN | 57 | |
| | Na$_2$CO$_3$ | 30 | |
| Cu-Sn | Cu(CN)$_2$ | 36 | pH = 12,5-13,0 |
| | Na$_2$SnO$_2$ | 63 | 5 A/dm² bei 65°C |
| | NaCN | 25 | |

Die beschichteten gesinterten Elektroden bzw. supraleitenden Materialien können aber auch aus einer nicht-wässrigen Lösung z.B. mit Silber-Partikeln beschichtet werden, indem Ag-Partikel aus einer nicht-wässrigen Suspension elektrophoretisch anodisch abgeschieden werden. Ein Beispiel einer nicht-wässrigen Suspension besteht z.B. aus 50 ml Aceton, 1,7 g Ag-Pulver und 0,15 g Nitrocellulose unter Anwendung einer Spannung von 350 V während 5 Sekunden. Zur Erzielung eines porenfreien Ueberzuges wird die Elektrode anschliessend noch in einem Bad von geschmolzenen Metallen, wie Pb-Sn, In, getaucht.

Mit dem erfindungsgemässen Verfahren, besonders der bevorzugten elektrophoretischen Abscheidung aus nicht-wässrigem Medium, lassen sich trotz der Sprödigkeit und Steifigkeit der einzusetzenden Ausgangsmaterialien (keramischen Pulver bzw. Vorstufen davon) überraschenderweise auf sehr einfache und wirtschaftliche Weise mit kurzen Abscheidungszeiten und unter optimaler Ausnützung der Ausgangsmaterialien keramische supraleitende Formkörper ganz beliebiger Form und Grösse herstellen. Die damit erhaltenen supraleitenden Beschichtungen sind sehr gleichmässig und weitgehend porenfrei; sie zeichnen sich ferner durch hohe Dichte und Kompaktheit sowie gute Haftfestigkeit auf dem Substrat aus, was für eine gute Supraleitung Voraussetzung ist. Ausserdem lassen sich Spulen innen einwandfrei beschichten.

Die Erfindung wird durch die nachfolgenden Beispiele näher erläutert.

Beispiel 1:

$Y_2O_3$ (99,99 %), $BaCO_3$ (99,99 %) und CuO (99,99 %) der Firma Kojundo Chem. (Japan) werden im Molgewichtsverhältnis von 1:4:6 (entspricht einem Molgewichtsverhältnis Y:Ba:Cu von 1:2:3) in einem Mörser gut gemischt. Das erhaltene Pulver wird verpresst, in der Luft bei 900°c während 24 Stunden vorgesintert und anschliessend während 6 Stunden langsam abgekühlt. Nachher wird das Material in einem Mörser pulverisiert. Man erhält ein keramisches Pulver der Zusammensetzung $YBa_2Cu_3O_x$ (x = 4,5-6,95); die durchschnittliche Partikelgrösse liegt bei 3 $\mu$m. 50 g dieses keramischen Pulvers werden in 250 ml Aceton, das 0,75 g Nitrocellulose (RS 60 der Firma Daicel Ltd., Japan) enthält, suspendiert. Diese Suspension wird mit 30 $\mu$l einer 10%igen wässrigen Lösung von Tetramethylammoniumhydroxid versetzt. Die Suspension wird in eine elektrochemische Zelle gegeben und mit 10 $\mu$l konzentrierter Schwefelsäure versetzt. Als Anode wird eine Goldspule verwendet. Während 5 Sekunden wird eine Spannung von 300 V (Gleichstrom) angelegt. Nach dieser Zeit hat sich auf der Goldspule eine 150 $\mu$m dicke Schicht aus $YBa_2Cu_3O_x$ (x = 4,5-6,95) gebildet. Anschliessend wird die beschichtete Spule während 7 Stunden bei 930°C im Ofen gesintert und dann langsam auf Raumtemperatur abgekühlt. Die erhaltene Probe zeigt Meissnereffekt.

Beispiel 2:

Nach dem in Beispiel 1 beschriebenen Verfahren wird aus 250 ml Methylethylketon, 1,0 g Nitrocellulose (RS 120 der Firma Daicel Co. Ltd., Japan), 40 g des in Beispiel 1 beschriebenen Pulvers, 10 $\mu$l KOH (1-molare wässrige Lösung) und 2 $\mu$l Phosphorsäure eine Suspension hergestellt. Mit dieser Suspension wird eine plattenförmige Silber-Anode beschichtet. Während 5 Sekunden wird eine Spannung von 300 V angelegt. Nach dieser Zeit hat sich auf der Silberplatte eine 150 um dicke Schicht des keramischen Materials gebildet. Anschliessend wird die beschichtete Platte während 12 Stunden bei 850°C im Ofen gesintert und abgekühlt. Die erhaltene Probe zeigt Meissnereffekt.

Beispiel 3:

Das in Beispiel 1 beschriebene Verfahren wird wiederholt, wobei als Ausgangspulver ein mit Hilfe der Mitfällungsmethode (Oxalatsalze) hergestelltes und anschliessend bei 900°C vorgesintertes käufliches (Y, Ba, Cu)$O_x$-pulver (1230S der Firma Fru'uchi Chemicals, Japan, Molgewichtsverhältnis Y:Ba:Cu = 1:2:3) verwendet und damit eine Platte aus Ni-Cr anodisch beschichtet wird. Die beschichtete Platte wird anschliessend während 6 Stunden bei 900°C im Ofen gesintert und dann abgekühlt. Die erhaltene Probe zeigt Meissnereffekt. Diese Probe wird bei 20-30°C unter einer Stromdichte von 12 mA/cm², 1,5 Minuten lang in einem elektrochemischen Bad aus 200 g $CuSO_4 \bullet 5H_2O$, 50 g konzentrierter Schwefelsäure und 1 l Wasser katodisch mit Kupfer beschichtet. Danach wird die mit Cu beschichtete Probe im Trockenschrank während 12 Stunden bei 70°C getrocknet.

Beispiel 4:

7,6 g $Y_2O_3$, 26,4 g $BaCO_3$ und 16,0 g CuO (Molgewichtsverhältnis Y:Ba:Cu = 1:2:3) werden in 250 ml Methylethylketon, 1,0 $\mu$l KOH (1-molare wässrige Lösung) und 15 $\mu$l Phosphorsäure suspendiert. Mit dieser Suspension wird wie in Beispiel 1 beschrieben eine spulenförmige Elektrode aus Cr-Al-Co anodisch beschichtet. Zur Sinterung wird die beschichtete Cr-Al-Co-Elektrode direkt als Heizdraht verwendet und bei der Temperatur von 900°C 5 Stunden lang in Gegenwart von Sauerstoff gesintert und nachher langsam während 6 Stunden bis auf Zimmertemperatur abgekühlt. Die erhaltene Probe zeigt Meissnereffekt.

Beispiel 5:

15 g des in Beispiel 1 beschriebenen vorgesinterten Pulvers, 10 mg $Al(NO_3)_3$ und 10 mg $La(NO_3)_3$ werden in 5 ml Wasser und 200 ml technischem Isopropanol (enthält etwa 6 % Wasser) dispergiert. Mit dieser Suspension wird eine spulenförmige Kathode aus Hastelloy (Ni-Mo-Cr-Fe) während 15 Sekunden bei 200 V beschichtet. Zur Sinterung wird die beschichtete Spule (Schichtdicke 100 $\mu$m) direkt als Heizdraht verwendet und bei 880°C während 10 Stunden unter Luft gesintert und dann abgekühlt. Sie zeigt Meissnereffekt.

Beispiel 6:

Mit der in Beispiel 3 beschriebenen Suspension werden Drähte aus Fe-Cr anodisch beschichtet und während 4 Stunden bei 950°C im Ofen gesintert und dann abgekühlt. Die beschichteten Drähte zeigen Meissnereffekt. Sie werden bei 60-70°C unter einer Stromdichte von 3 mA/cm² 1 Minute in einem elektrochemischen Bad aus 2 g Au, 15 g $Na_2HPO_4$ und 1 l Wasser kathodisch mit Au beschichtet. Nachher wird die mit Au beschichtete Probe im Trockenschrank bei 80°C 10 Stunden lang getrocknet.

Beispiel 7:

$Bi_2O_3$ (99,999 %) $SrCO_3$ (99,9 %), $CaCO_3$ (99,99 %) und CuO (99,99 %) der Firma Kojundo Chem. (Japan) werden im Molargewichtsverhältnis von 1:2:2:4 (entspricht einem Molekulargewichtsverhältnis Bi:Sr:Ca:Cu von 1:1:1:2) in einem Mörser gut gemischt. Das erhaltene Pulver wird verpresst, in der Luft bei 800°C während 8 Stunden vorgesintert und während 2 Stunden langsam abgekühlt. Nachher wird das Material in einem Mörser pulverisiert. Man erhält ein keramisches Pulver der Zusammensetzung $BiSrCaCu_2O_x$; die durchschnittliche Partikelgrösse liegt bei 5 µm. 10 g dieses Pulvers werden in 50 ml Aceton, das 0,3 g Nitrocellulose (Qualität RS 60 der Firma Daicel Ltd., Japan) enthält, suspendiert. Diese Suspension wird mit 6 µl einer 10%-igen alkoholischen Lösung von Tetramethylammoniumhydroxid versetzt. Die Suspension wird in eine elektrochemische Zelle gegeben und mit 10 µl konzentrierter Schwefelsäure versetzt. Als Anode wird ein Silberdraht verwendet. Während 2 Sekunden wird eine Spannung von 500 V (Gleichstrom) angelegt. Nach dieser Zeit hat sich auf dem Silberdraht eine 200 µm dicke Oxid-Schicht $BiSrCa$-$Cu_2O_x$ gebildet. Anschliessend wird der beschichtete Draht während 8 Stunden bei 870°C im Ofen gesintert und dann langsam auf Raumtemperatur abgekühlt.

Beispiel 8:

Das in Beispiel 7 beschriebene Verfahren wird wiederholt, wobei als Ausgangspulver ein mit Hilfe der Mitfällungsmethode (Oxalatsalze) hergestelltes und anschliessend bei 800°C vorgesintertes käufliches $Bi_{0,7}Pb_{0,3}SrCaCu_{1,8}O_x$-Pulver (Qualität 73-1118S der Firma Fru'uchi Chemical, Japan) verwendet und damit eine Spule aus Ni-Cr anodisch beschichtet wird. Die beschichtete Spule wird anschliessend 24 Stunden bei 845°C im Ofen gesintert und dann abgekühlt. Die erhaltene Probe zeigt Meissnereffekt.

Beispiel 9:

$Tl_2O_3$ (99,9 %) $CaCO_3$ (99,99 %), $BaCO_3$ (99,99 %) und CuO (99,99 %) der Firma Kojundo Chem. (Japan) werden im Molargewichtsverhältnis Tl:Ca:Ba:Cu von 2:2:2:3 in einem Mörser gut gemischt. Das erhaltene Pulver wird verpresst, in der Luft bei 900°C während 2 Stunden vorgesintert und dann während 1 Stunde langsam abgekühlt. Nachher wird das Material in einem Mörser pulverisiert. 10 g dieses Pulvers werden in 50 ml Aceton, das 0,15 g Nitrocellulose (Qualität RS 60 der Firma Daicel Ltd., Japan) enthält, suspendiert. Diese Suspension wird mit 12 µl einer 10%-igen wässrigen Lösung von Tetramethylammoniumhydroxid versetzt. Die Suspension wird in eine elektrochemische Zelle gegeben und mit 12 µl konzentrierter Schwefelsäure versetzt. Als Anode wird eine Goldspule verwendet. Während 3 Sekunden wird eine Spannung von 300 V (Gleichstrom) angelegt. Nach dieser Zeit hat sich auf der Goldspule eine 100 µm dicke Schicht $Tl_2Ca_2Ba_2Cu_3O_x$ gebildet. Anschliessend wird die beschichtete Spule während 5 Stunden bei 920°C im Ofen gesintert und dann langsam auf Raumtemperatur abgekühlt. Die erhaltene Probe zeigt Meissnereffekt.

**Patentansprüche**

1. Verfahren zur Herstellung von supraleitenden Materialien in an sich beliebiger Form, dadurch gekennzeichnet, dass man auf Metallelektroden oder metallisierten Elektroden entsprechender Form aus einer Suspension eine supraleitende keramische Verbindung elektrophoretisch abscheidet und die beschichtete Elektrode anschliessend bei erhöhter Temperatur sintert.

2. Verfahren nach Anspruch 1, dadurch gekennzeichnet, dass die supraleitende keramische Verbindung eine solche mit einer Sprungtemperatur $T_c$ von mindestens 4 K, besonders eine Verbindung mit einer Sprungtemperatur $T_c$ zwischen 10 und 125 K oder mehr ist.

3. Verfahren nach Anspruch 1, dadurch gekennzeichnet, dass die supraleitende Verbindung ein Mischoxid aus mindestens einer seltenen Erde, einem Erdalkalimetall und Kupfer ist.

4. Verfahren nach Anspruch 1, dadurch gekennzeichnet, dass die supraleitende Verbindung ein Mischoxid aus Lanthan, Kupfer und Barium, Strontium oder Calcium ist.

5. Verfahren nach Anspruch 1, dadurch gekennzeichnet, dass die supraleitende Verbindung eine solche der Formel I
$$MBa_2Cu_3O_x \quad (I)$$
ist, worin x 4,5 bis 6,95 ist und der Rest M Lu, Yb, Tm, Er, Dy, Ho, Tb, Gd, Eu, Sm, Sc oder Y ist.

6. Verfahren nach Anspruch 5, dadurch gekennzeichnet, dass M in Formel I Yttrium darstellt und x die angegebene Bedeutung hat.

7. Verfahren nach Anspruch 1, dadurch gekennzeichnet, dass die supraleitende Verbindung ein Mischoxid aus Wismuth, Strontium, Galcium und Kupfer oder aus Thallium, Barium, Calcium und Kupfer ist.

8. Verfahren nach Anspruch 1, dadurch gekennzeichnet, dass man als Ausgangsprodukte zur Erzeugung der supraleitenden keramischen Verbindungen vorgesinterte Pulver aus den abzuscheidenden supraleitenden Verbindungen anwendet.

9. Verfahren nach Anspruch 8, dadurch gekennzeichnet, dass man zur Herstellung der vorgesinterten Pulver anorganische Ausgangsmaterialien in den gewünschten Molgewichtsverhältnissen mischt und bei Temperaturen von 600-1050°C vorsintert.

10. Verfahren nach Anspruch 9, dadurch gekennzeichnet, dass man als Ausgangsmaterialien ein Oxid einer seltenen Erde, Kupferoxid und die restlichen Ausgangsmaterialien als Oxid, Fluorid oder Carbonat einsetzt.

11. Verfahren nach Anspruch 9, dadurch gekennzeichnet, dass man als Ausgangsmaterialien nach der Mitfällungsmethode hergestellte Pulver verwendet.

12. Verfahren nach Anspruch 1, dadurch gekennzeichnet, dass man zur Erzeugung der supraleitenden keramischen Verbindungen anorganische Ausgangsmaterialien verwendet, die dann nach der elektrophoretischen Abscheidung gesintert werden.

13. Verfahren nach Anspruch 1, dadurch gekennzeichnet, dass man die beschichtete Elektrode bei Temperaturen zwischen 600 und 1050°C in der Luft, in Sauerstoff oder in Inertgasatmosphäre sintert.

14. Verfahren nach Anspruch 1, dadurch gekennzeichnet, dass man zur Sinterung die beschichtete Elektrode als Heizelement verwendet.

15. Verfahren nach Anspruch 1, dadurch gekennzeichnet, dass man die elektrophoretische Abscheidung in einem wasserhaltigen System durchführt, welches ein organisches polares Lösungsmittel enthält.

16. Verfahren nach Anspruch 15, dadurch gekennzeichnet, dass das wasserhaltige System Isopropanol, das bis zu ca. 10 Gew.% Wasser enthält, ist.

17. Verfahren nach Anspruch 15, dadurch gekennzeichnet, dass man einen Elektrolyt zusetzt und als Elektrolyt Lanthannitrat verwendet.

18. Verfahren nach Anspruch 1, dadurch gekennzeichnet, dass man die elektrophoretische Abscheidung in einem nicht-wässrigen Medium, das im wesentlichen ein wasserfreies organisches Lösungsmittel, eine starke Base als Elektrolyt, eine starke Säure und gegebenenfalls ein im Lösungsmittel gelöstes Bindemittel enthält, durchführt.

19. Verfahren nach Anspruch 18, dadurch gekennzeichnet, dass man als organisches Lösungsmittel hochreines Aceton, als starke Base Tetramethylammoniumhydroxid, als starke Säure hochkonzentrierte Schwefelsäure und als Bindemittel Nitrocellulose verwendet.

20. Verfahren nach Anspruch 15, dadurch gekennzeichnet, dass die Abscheidung zwischen 10 und 500 V und bei einer Stromdichte zwischen 5 und 30 mA/cm$^2$ erfolgt.

21. Verfahren nach Anspruch 1, dadurch gekennzeichnet, dass man auf der beschichteten und gesinterten Elektrode eine Metallbeschichtung aus einer wässrigen oder nicht-wässrigen Lösung erzeugt.

22. Nach dem Verfahren gemäss Anspruch 1 erhaltenes supraleitendes Material.